**Europäisches Patentamt**

**European Patent Office**

**Office européen des brevets**

(19)

(11) Veröffentlichungsnummer: **0 135 075 B1**

(12)

# EUROPÄISCHE PATENTSCHRIFT

(45) Veröffentlichungstag der Patentschrift:
**05.10.88**

(51) Int. Cl.⁴: **H 03 K 19/094**

(21) Anmeldenummer: **84108931.1**

(22) Anmeldetag: **27.07.84**

(54) MOS-Inverterschaltung.

(30) Priorität: **18.08.83 DE 3329874**

(43) Veröffentlichungstag der Anmeldung:
**27.03.85 Patentblatt 85/13**

(45) Bekanntmachung des Hinweises auf die Patenterteilung:
**05.10.88 Patentblatt 88/40**

(84) Benannte Vertragsstaaten:
**AT DE FR GB IT**

(56) Entgegenhaltungen:
GB - A - 2 069 273
US - A - 4 069 430
US - A - 4 506 350

PATENTS ABSTRACTS OF JAPAN, Band 4, Nr.
170(E-35)(652), 22. November 1980; & JP - A - 55 115 729
(TOKYO SHIBAURA DENKI K.K.) 05.09.1980

(73) Patentinhaber: **Siemens Aktiengesellschaft Berlin und München, Wittelsbacherplatz 2, D-8000 München 2 (DE)**

(72) Erfinder: **Schrenk, Hartmut, Dr., Fasanenweg 22, D-8013 Haar (DE)**

## Beschreibung

Die Erfindung betrifft eine MOS-Inverterschaltung nach dem Oberbegriff des Patentanspruchs 1.

MOS-Inverterschaltungen bestehen bekanntlich aus einer Reihenschaltung eines Steuer-MOS-FET und eines Last-MOS-FET. Aus dem IBM Technical Disclosure Bulletin, Vol. 22, No. 11, April 1980, ist beispielsweise eine Inverterschaltung bekannt, in welcher der Steuer-MOS-FET vom Anreicherungstyp und der Last-MOS-FET vom Verarmungstyp ist. Eine derartige logische Schaltung in N-Kanal-Silikon-Gatetechnik arbeitet typischerweise bei einer Betriebsspannung von 5 V, d.h. alle durchgeschalteten Steuer-MOS-FETs belasten mit dem durch den Last-MOS-FET fliessenden Strom die Spannungsquelle. In vielen Fällen ist es jedoch erforderlich, eine zweite höhere Betriebsspannung von beispielsweise 20 V zu verwenden, wobei eine derartige Spannungsquelle häufig eine sehr geringe Stromabgabe besitzen kann. Ein bekanntes Anwendungsbeispiel für den Einsatz von höheren Betriebsspannungen sind E²PROMs, bei welchen die höhere Zusatzspannung beispielsweise durch eine Spannungsvervielfacher-Schaltung geringer Leistungsfähigkeit aus einer 5 V-Spannungsquelle gewonnen wird. Besonders für diese Art von Spannungsquelle stellen herkömmliche MOS-Inverterschaltungen eine unerwünschte, hohe Strombelastung dar.

Aus der US-A-4 506 350 ist ein nichtflüchtiges Halbleiterspeichersystem bekannt, in dem aus zwei unterschiedlich hohen Betriebsspannungen eine wesentlich höhere zusätzliche Spannung erzeugt wird, die mit Hilfe einer gattungsgemässen MOS-Inverterschaltung nachgeschaltete Schaltungsteile ansteuert.

Der Erfindung lag daher die Aufgabe zugrunde, eine MOS-Inverterschaltung der oben genannten Art anzugeben, mit welcher die Strombelastung der Spannungsquelle höherer Betriebsspannung reduziert ist.

Diese Aufgabe wird erfindungsgemäss durch die Merkmale des kennzeichnenden Teils des Patentanspruchs 1 gelöst.

Weiterbildungen der Erfindung ergeben sich aus den Unteransprüchen. Im folgenden wird die Erfindung anhand von zwei Ausführungsbeispielen weiter beschrieben.

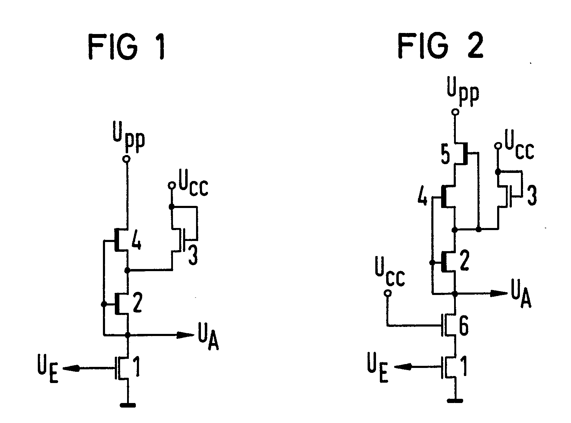

Die Fig. 1 bis 2 zeigen jeweils ein Beispiel einer MOS-Inverterschaltung.

Der MOS-Inverter in Fig. 1 besteht aus einem Steuer-Mos-FET 1 vom Anreicherungstyp, einem ersten und zweiten Last-MOS-FET 2, 4 vom Verarmungstyp und einem als Diode geschalteten dritten MOS-FET 3 vom Anreicherungstyp. Die beiden Last-MOS-FETs 2, 4 sind in Reihe geschaltet und über einen ersten Knotenpunkt mit der gesteuerten Strecke des Steuer-MOS-FET 1 verbunden. Die Steuereingänge des ersten und zweiten Last-MOS-FET 2, 4 liegen ebenfalls am ersten Knotenpunkt, an welchem das Ausgangssignal $U_A$ des Inverters abgreifbar ist. Ein zweiter Knotenpunkt am Drainanschluss des ersten bzw. am Sourceanschluss des zweiten Last-Transistors 2, 4 ist parallel zum zweiten Last-MOS-FET 4 über den als Diode geschalteten dritten MOS-FET 3 mit einer ersten Betriebsspannung $U_{cc}$ verbunden. Die beiden Last-Transistoren sind mit einer höheren, zweiten Betriebsspannung $U_{PP}$ belegt. Diese liegt beispielsweise im Bereich von 20 V, während die erste Betriebsspannung 5 V aufweist.

Wird der Steuer-MOS-FET 1 durchgeschaltet, so wird durch die Spannungsteilung an den Last-Transistoren 2, 4 die Spannung am ersten und zweiten Knotenpunkt gegenüber der zweiten Betriebsspannung $U_{PP}$ abgesenkt. Fällt die Spannung am zweiten Knotenpunkt unter den Wert der Einsatzspannung des dritten MOS-FET 3, so wird dieser leitend, wobei über den ersten Last-MOS-FET 2 und den Steuer-MOS-FET 1 ein Strom aus der Spannungsquelle der ersten Betriebsspannung $U_{CC}$ fliesst. Wenn der Betrag der Einsatzspannung des zweiten Last-MOS-FET 4 kleiner als die Spannung am zweiten Knoten ist, die durch die Spannungsteilung durch den dritten MOS-FET 3, den ersten Last-MOS-FET 2 und den Steuer-MOS-FET 1 gegeben ist, so führt der zweite Last-MOS-FET 4 keinen Strom mehr. Somit muss die Spannungsquelle der zweiten Betriebsspannung keinen stationären Strom abgeben. Diese Bedingung ist optimal erfüllt, wenn der dritte MOS-FET 3 so dimensioniert ist, dass er besser leitet als der erste Last-MOS-FET 2, wenn die Einsatzspannung des dritten MOS-FET 3 niedrig ist, und der Betrag den Einsatzspannungen des zweiten Last-MOS-FET 4 hoch ist.

Die Ausgangsspannung $U_A$ am ersten Knoten liegt – abhängig von einer Eingangsspannung $U_E$ – entweder bei 0V oder bei der zweiten Betriebsspannung $U_{PP}$. Ist die Ausgangsspannung grösser als die erste Betriebsspannung $U_{cc}$, so ist der dritte MOS-FET 3 gesperrt und belastet die Spannungsquelle der zweiten Betriebsspannung $U_{PP}$ nicht.

Fig. 2 zeigt eine Weiterbildung der Inverterschaltung aus Fig. 1. Sie ist besonders für hohe Betriebsspannungen geeignet, bei welchen die zweite Betriebsspannung $U_{PP}$ oberhalb der technologiebedingten, gateunterstützten Durchbruchsspannung $U_{pn}$ (G) eines MOS-FET liegt, dessen Gate-Spannung auf 0V gehalten wird. Ein möglicher $U_{pn}$ (G)-Durchbruch am Drainanschluss des zweiten Lasttransistors 4 wird durch einen fünften MOS-FET 5 vom Verarmungstyp verhindert. Dessen gesteuerte Strecke verbindet die zweite Betriebsspannung $U_{PP}$ mit der Reihenschaltung der ersten und zweiten Last-MOS-FET 2, 4. Sein Steuereingang ist mit dem zweiten Knotenpunkt verbunden. Das Steuergate des fünften MOS-FET 5 hat eine Spannung, die entsprechend der beschriebenen Spannungsteilung wenig kleiner ist als die Betriebsspannung $U_{cc}$. Damit ist auch die gategespeiste Durchbruchspannung des fünften MOS-FET 5 um diesen Betrag höher als die entsprechende Durchbruchspannung des zweiten Last-MOS-FET 4 in Fig. 1.

Ein $U_{pn}$ (G)-Durchbruch am Drainanschluss des Steuer-MOS-FET 1 wird durch einen vorgeschalteten, in Reihe liegenden sechsten MOS-FET 6 verhindert, dessen Steuereingang fest mit der ersten Betriebsspannung $U_{cc}$ belegt ist. Um diesen Betrag ist auch die Durchbruchspannung des sechsten MOS-FET 6 im Vergleich zur Durchbruchspannung des Steuer-MOS-FET 1 nach Fig. 1 angehoben. Im leitenden Zustand des Steuer-MOS-FET 1 ist der Steuereingang des fünften MOS-FET 5 zusammen mit dem zweiten Knoten mit einer Spannung von einigen Volt beaufschlagt. Etwa um diesen Spannungswert ist die Durchbruchsspannung $U_{pn}$ (G) des fünften Transistors gegenüber der Durchbruchspannung des zweiten Last-Transistors 4 angehoben, im Vergleich zu einer Schaltung nach Fig. 1.

**Patentansprüche**

1. MOS-Inverterschaltung mit einem MOS-FET (3) vom Anreicherungstyp, mit einer Reihenschaltung dreier MOS-FETs (1, 2, 4), eines ersten (2) und eines zweiten (4) Last-MOS-FET vom Verarmungstyp, deren Gates mit einem ersten Knotenpunkt verbunden sind, sowie eines mit dem ersten Knotenpunkt verbundenen Steuer-MOS-FET (1) vom Anreicherungstyp und mit einer ersten ($U_{CC}$) und einer höheren zweiten, an der Reihenschaltung liegenden Betriebsspannung ($U_{pp}$), dadurch gekennzeichnet, dass der MOS-FET (3) vom Anreicherungstyp als Diode geschaltet, an einen durch den Verbindungspunkt der gesteuerten Strecken des ersten (2) und zweiten (4) Last-MOS-FET gebildeten zweiten Knotenpunkt angeschlossen und mit der ersten Betriebsspannung ($U_{CC}$) belegt ist.

2. MOS-Inverterschaltung nach Anspruch 1, dadurch gekennzeichnet, dass zum ersten (2) und zweiten (4) Last-MOS-FET ein fünfter MOS-FET (5) vom Verarmungstyp in Reihe geschaltet ist, dessen Steuereingang mit dem zweiten Knotenpunkt verbunden ist.

3. MOS-Inverterschaltung nach Anspruch 1 oder 2, dadurch gekennzeichnet, dass ein Spannungsteiler, bestehend aus dem Steuer-MOS-FET (1), dem ersten Last-MOS-FET (2) und dem MOS-FET (3) vom Anreicherungstyp, so dimensioniert ist, dass der Betrag der Einsatzspannung des zweiten Last-MOS-FET (4) kleiner als die Spannung am zweiten Knotenpunkt ist.

4. MOS-Inverterschaltung nach einem der Ansprüche 1 bis 3, dadurch gekennzeichnet, dass der MOS-FET (3) vom Anreicherungstyp so dimensioniert ist, dass er besser leitet als der erste Last-MOS-FET (2).

5. MOS-Inverterschaltung nach einem der Ansprüche 1 bis 4, dadurch gekennzeichnet, dass der MOS-FET (3) vom Anreicherungstyp so dimensioniert ist, dass· er eine niedrige Einsatzspannung aufweist.

**Claims**

1. A MOS inverter circuit comprising a MOS-FET (3) of the enhancement type, which a series arrangement of three MOS-FETs (1,2,4); a first (2) and a second (4) load MOS-FET of the depletion type, whose gates are connected to a first nodal point; and a control MOS-FET (1) of the enhancement type connected to the first nodal point, and with a first operating voltage ($U_{CC}$) and a higher, second operating voltage ($U_{PP}$) connected to the series arrangement, characterised in that the MOS-FET (3) of the enhancement type is connected as a diode between a second nodal point, formed by the connection point of the controlled paths of the first (2) and second (3) load MOS-FETs, and the first operating voltage ($U_{CC}$).

2. A MOS inverter circuit as claimed in Claim 1, characterised in that the first (2) and second (4) load MOS-FETs are connected in series with a fifth MOS-FET (5) of the depletion type whose control input is connected to the second nodal point.

3. A MOS inverter circuit as claimed in Claim 1 or 2, characterised in that a voltage divider, consisting of the control MOS-FET (1), the first load MOS-FET (2), and the MOS-FET (3) of the enhancement type, is dimensioned to be such that the amount of the threshold voltage of the second load MOS-FET (4) is smaller than the voltage connected to the second nodal point.

4. A MOS inverter circuit as claimed in one of Claims 1 to 3, characterised in that the MOS-FET (3) of the enhancement type is dimensioned to be such that it is a better conductor than the first load MOS-FET (2).

5. A MOS inverter circuit as claimed in one of Claims 1 to 4, characterised in that the MOS-FET (3) of the enhancement type is dimensioned to be such that it has a low threshold voltage.

**Revendications**

1. Circuit inverseur MOS comportant un transistor MOS-FET (3) du type à enrichissement, un circuit série formé de trois transistors MOS-FET (1,2,4), d'un premier (2) et d'un second (4) transistors MOS-FET de charge du type à appauvrissement, dont les grilles sont reliées à un premier nœud, ainsi que d'un transistor MOS-FET de commande (1) du type à enrichissement, relié au premier nœud, et une première tension de service ($U_{CC}$) et une seconde tension de service supérieure ($U_{PP}$) appliquée au circuit série, caractérisé par le fait que le transistor MOS-FET (3) du type à enrichissement, branché en tant que diode, est raccordé à un second nœud formé par le point de liaison entre les sections commandées du premier transistor MOS-FET de charge (2) et du second transistor MOS-FET de charge (4) et est placé à la première tension de service ($U_{CC}$).

2. Circuit inverseur MOS suivant la revendication 1, caractérisé par le fait qu'un cinquième transistor MOS-FET (5) du type à appauvrissement, dont l'entrée de commande est reliée au second nœud, est branché en série avec le premier transistor MOS-FET de charge (2) et le second transistor MOS-FET de charge (4).

3. Circuit inverseur MOS suivant la revendication 1 ou 2, caractérisé par le fait que le diviseur de tension constitué par le transistor MOS-FET de commande (1), le premier transistor MOS-FET de charge (2) et le transistor MOS-FET (3) du type à enrichissement, est dimensionné de telle sorte que la valeur de la tension de déclenchement du second transistor MOS-FET de charge (4) est inférieure à la tension présente sur le second nœud.

4. Circuit inverseur MOS suivant l'une des revendications 1 à 3, caractérisé par le fait que le transistor MOS-FET (3) du type à enrichissement est dimensionné de telle sorte qu'il conduit mieux que le premier transistor MOS-FET de charge (2).

5. Circuit inverseur MOS suivant l'une des revendications 1 à 4, caractérisé par le fait que le transistor MOS-FET (3) du type à enrichissement est dimensionné de telle sorte qu'il possède une faible tension de déclenchement.

# FIG 1

# FIG 2